# EUROPEAN PATENT SPECIFICATION

(11) **EP 0 739 032 B1**
(45) Date of publication and mention of the grant of the patent: **04.05.2005**
(21) Application number: 96301226.5
(22) Date of filing: 23.02.1996
(51) Int. Cl.: H01L 21/762, H01L 21/316

(54) **Isolation method of semiconductor device**
Verfahren zur Isolierung einer Halbleiteranordnung
Méthode d'isolation d'un dispositif semiconducteur

(30) Priority: 21.04.1995 KR 9509455
(43) Date of publication of application: 23.10.1996
(73) Proprietor: Samsung Electronics Co., Ltd., Suwon-city, Kyungki-do 441-370 (KR)
(72) Inventor: Park, Moon-han, Kwanak-gu, Seoul (KR)
(74) Representative: Ertl, Nicholas Justin

(56) References cited:
- EP-A- 0 245 538
- EP-A- 0 532 361
- GB-A- 2 190 241
- US-A- 4 942 137
- PATENT ABSTRACTS OF JAPAN vol. 010, no. 170 (E-412), 17 June 1986 & JP 61 022663 A (HITACHI SEISAKUSHO KK), 31 January 1986, & JP 61 022 663 A (HITACHI SEISAKUSHO K.K.) 31 January 1986
- 1995 INTERNATIONAL ELECTRON DEVICES MEETING, 11 - 14 December 1994, SAN FRANSISCO, CA., pages 675-678, XP000585579 PARK T ET AL: "SELF-ALIGNED LOCOS/TRENCH (SALOT) COMBINATION ISOLATION TECHNOLOGY PLANARIZED BY CHEMICAL MECHANICAL POLISHING"
- PATENT ABSTRACTS OF JAPAN vol. 013, no. 525 (E-850), 22 November 1989 & JP 01 215036 A (SEIKO EPSON CORP), 29 August 1989,
- PROCEEDINGS OF THE INTERNATIONAL ELECTRON DEVICES MEETING, WASHINGTON, DEC. 3 - 6, 1989, no. -, 3 December 1989, INSTITUTE OF ELECTRICAL AND ELECTRONICS ENGINEERS, pages 583-586 583 - 586, XP000448272 HISAMUNE Y S ET AL: "A 3.6 UM2 MEMORY CELL STRUCTURE FOR 16MB EPROMS A 3.6 MU M2 MEMORY CELL STRUCTURE FOR 16MB EPROMS"

## Description

The present invention relates to an isolation method for a semiconductor device, and more particularly, to an isolation method for a semiconductor device in which two different isolation layers are formed to provide a wider inactive region and a narrower inactive region to improve electrical characteristics of the semiconductor device.

With the high integration of semiconductor devices, device isolation regions are reduced, such that 0.45µm and 0.25µm design-rule technologies are needed for a 64Mb and 256Mb DRAM, respectively. Also, since the formation of the device isolation region is generally the initial step in the fabrication of virtually any such device and influences the dimensions of an active region and the process margin in a subsequent process step, means for planarizing the step difference of a field insulating layer is needed.

Generally, the local oxidation of silicon (LOCOS) method, which is widely used in the fabrication of semiconductor devices, results in several problems: a bird's beak phenomenon caused by lateral oxidation of the substrate, crystal defects in the substrate due to a buffer layer stress resulting from thermal processing, and an undesired redistribution of ion-implanted impurities for a channel stopper layer. Each of these problems of the LOCOS method contribute to diminished electrical characteristics for higher levels of integration.

In order to solve the problems of the LOCOS method, a device isolation method using a trench is proposed. Here, it is possible to reduce the drawbacks of the LOCOS method caused by the thermal oxidation process, since the field oxide layer is not formed by a thermal oxidation process.

However, in this process of forming the trench in the substrate, the crystal defect still appears in the substrate and in the case of refilling the insulating material into the trench a profile of insulating material refilled in a wide trench pattern is not uniform, thereby causing an unstable device isolation characteristic and a structural step difference, which creates another problem.

Device isolation methods by LOCOS and trench will be explained briefly as follows with reference to the drawings.

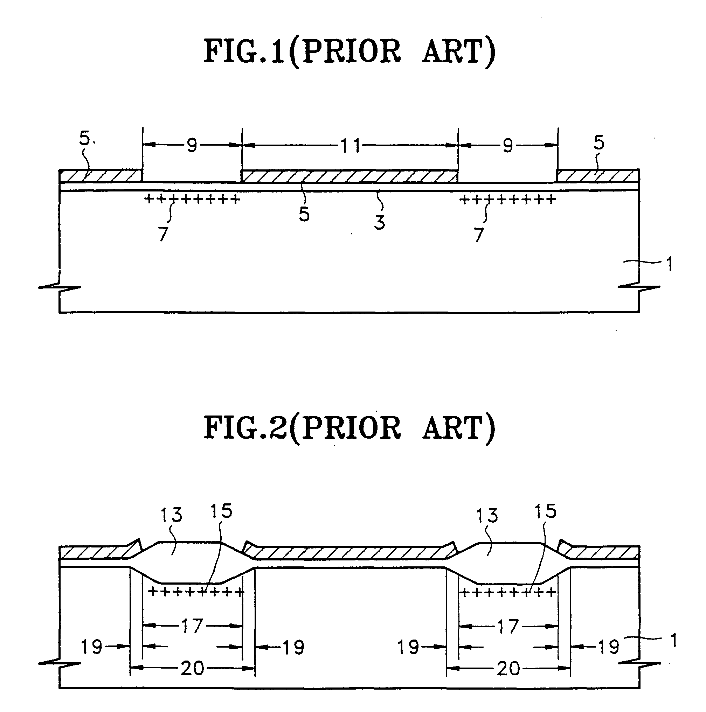

Figs. 1 and 2 are cross sectional views for explaining the conventional LOCOS isolation method.

Referring to Fig. 1, a pad oxide layer 3 and a silicon nitride layer 5 are stacked on a semiconductor substrate 1 and then silicon nitride layer 5 in an inactive region 9 is removed by photo-lithography. Thereafter, channel stopper ions 7 are implanted into inactive region 9 to form separately inactive region 9 and an active region 11.

Referring to Fig. 2, if the semiconductor substrate on which inactive region 9 and active region 11 are separately formed, is put into an oxidation furnace so as to be subjected to a thermal oxidation process under predetermined conditions, a field oxide layer 13 is formed on inactive region 9.

Fig. 2 shows a device isolation structure formed by the LOCOS method. A channel stopper region 15 where redistribution of impurity ions is realized by thermal diffusion is located under field oxide layer 13. Also, during the thermal oxidation process, pad oxide layer 3 adjacent to inactive region 9 is oxidized in the direction of the active region thereby generating the bird's beak phenomenon. Accordingly, the length 20 of the inactive region becomes greater than that of initial inactive region 17 by a bird's beak generation region 19. The bird's beak phenomenon restricts the limit of a design rule for forming a micro pattern, and thereby is a hindrance in the high integration of a semiconductor.

Also, in the LOCOS method, the field oxide layer is thermally grown up to a thickness of about 5,000Å and crystal defects are generated by the stress at a boundary of the active region under the silicon nitride layer which is selectively covered on the semiconductor substrate, so leakage current between devices increases.

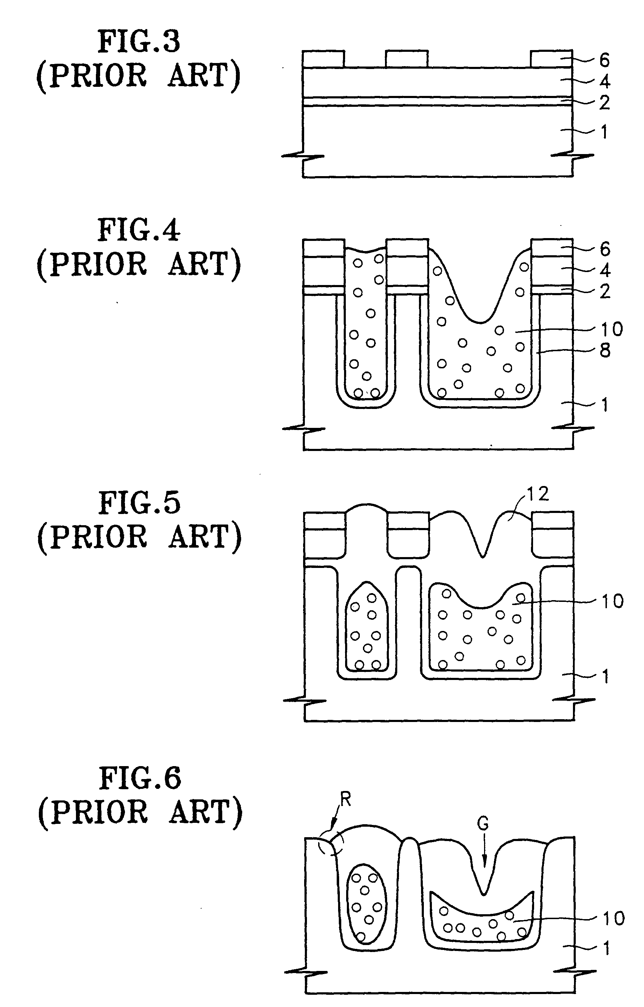

Figs. 3 to 6 are cross sectional views according to process order for explaining the conventional trench isolation method.

Referring to Fig. 3, a pad oxide layer 2 of about 240Å is formed on semiconductor substrate 1 and then the silicon nitride layer 4 of about 1,500Å is formed by low-pressure chemical vapor deposition (LPCVD) and then in sequence a thermal oxide layer 6 of about 1,000Å is formed, then the thermal oxide layer of the inactive region is removed by a photolithography process.

Referring to Fig. 4, nitride layer 4 and pad oxide layer 2 are reactive-ion-etched using the thermal oxide layer remaining on the active region as an etching mask, and then semiconductor substrate 1 is etched by dry etching to form a trench. At this time, the thermal oxide layer, the etching mask, is etched together with the nitride layer, the pad oxide layer and the trench according to an etching selection ratio, so that a little amount of the thermal oxide layer remain. Also, the trenches of a narrow region and a wide region coexist in the semiconductor substrate according to the design rule of the semiconductor device.

Next, a side wall oxide layer 8 is formed inside the trench by the thermal oxidation method, and polycrystalline silicon 10 is deposited to a thickness of 5,000Å or more, and is etched anisotropically in order to fill the polycrystalline silicon only in the trench. At this time, while the trench of the narrow region is completely filled, a central portion of the trench of the wide region is depressed to generate a kind of loading effect, so that a filling profile differs according to the size of the trench region.

Referring to Fig. 5, a field oxide layer 12 is formed on the polycrystalline silicon filling the trench by the thermal oxidation method. However, the depressed portion of the trench of the wide region is not planarized.

Referring to Fig. 6, after buffer layers (thermal oxide layer, silicon nitride layer and pad oxide layer) are wet-etched by buffered oxide etchant (a mixed solution of ammonium fluoride (NH₄F) and hydrogen fluoride (HF) in a ratio of 7:1) and phosphoric acid solution, a sacrifice oxide layer (not shown) is grown up, and then the grown up sacrifice oxide layer is wet-etched again to finish the device isolation process.

In the trench isolation method, a gate line and a bit line may be shorted, or a wiring characteristic deteriorated, during a subsequent process due to the depressed phenomenon (G) of the polycrystalline silicon of the central portion of the trench of the wide region, resulting in the decrease of yield.

Also, due to the bird's beak phenomenon (R) caused during formation of the field oxide layer, not only is there a limit to reduction of a separated region, but also a predetermined thickness of the field oxide layer is etched simultaneously at the time of etching the thermal oxide layer of the buffer layer, so the thickness of the field oxide layer needs to be further increased when taking into account such a process margin, which causes a more serious bird's beak phenomenon.

To solve the problems of the trench device isolation method, a chemical-mechanical polishing (CMP) method has been proposed.

In the CMP method, since the insulating material overfilling the trench is removed in the horizontal direction, the CMP method has been considered as an ideal method for completely filling the trench and thereafter etching the insulating material overfilling the trench. However, also in the CMP method, if the width of the trench becomes on the order of several millimetres, a dishing phenomenon in which the central portion of the wide trench region is depressed in a dish shape, is generated to cause an unstable device isolation characteristic and a structural step difference.

An isolation process involving forming trenches and growing thermal oxide films around the trenches is disclosed in JP 61-22663.

JP 3-101249 describes a method of making an isolation structure in which a LOCOS process combines with a trench-filling process.

EP 532361 describes a process of forming an isolation structure by etching a trench and filling the trench. The remainder of the semiconductor surface is then oxidised.

GB 2190241 describes a similar process in which a pair of trenches are filled with oxide. A thin oxide layer is then formed. A layer of silicon nitride above the thin oxide layer is patterned to expose the thin oxide layer between the trenches. Thermal oxidation is then used to grow a thick oxide layer in the exposed region between the trenches, following which the silicon nitride is removed.

According to the invention, there is provided a method as set out in claim 1.

The present invention provides an isolation method for a semiconductor device where the electrical characteristics of the semiconductor device can be improved.

Also, the above object can be accomplished by an isolation method of a semiconductor device according to the present invention including the steps of: forming a first pattern on a semiconductor substrate to expose a first inactive region of said substrate; etching the exposed semiconductor substrate by the first pattern to form a trench; forming a first device isolation layer by filling insulating material in the trench; forming a second pattern on the semiconductor substrate to expose a second inactive region of the substrate; and forming a second device isolation layer in the second inactive region by the local oxidation method.

Here, a CMP or reactive ion etching (RIE) step may be further included for etching back the first device isolation layer after the step of forming the first device isolation layer.

It is preferable that the bird's beak, which is generated during the local oxidation for forming the second inactive region, shares a boundary with the trench.

In the present invention, it is preferable that the first inactive region exists in the cell array portion and the second inactive region exists in the peripheral circuit portion. It is further preferable that the first device isolation layer is formed of a CVD oxide layer.

According to the isolation method of a semiconductor device of the present invention, dishing can be prevented and proper device isolation can be achieved without exposure of the active region between the first and second isolation layers.

Specific embodiments of the present invention are described in detail below, with reference to the attached drawings, in which:
Figs. 1 and 2 are cross-sectional views for explaining a conventional LOCOS device isolation method;
Figs. 3-6 are cross-sectional views for explaining a conventional trench device isolation method; and
Figs. 7-14 are cross-sectional views for explaining a device isolation method according to embodiments of the present invention.

A device isolation method by the present invention includes the steps of: (a) forming a first device isolation layer by a trench isolation method on a narrow inactive region and then (B) forming a second device isolation layer on a wide inactive region by the LOCOS isolation method.

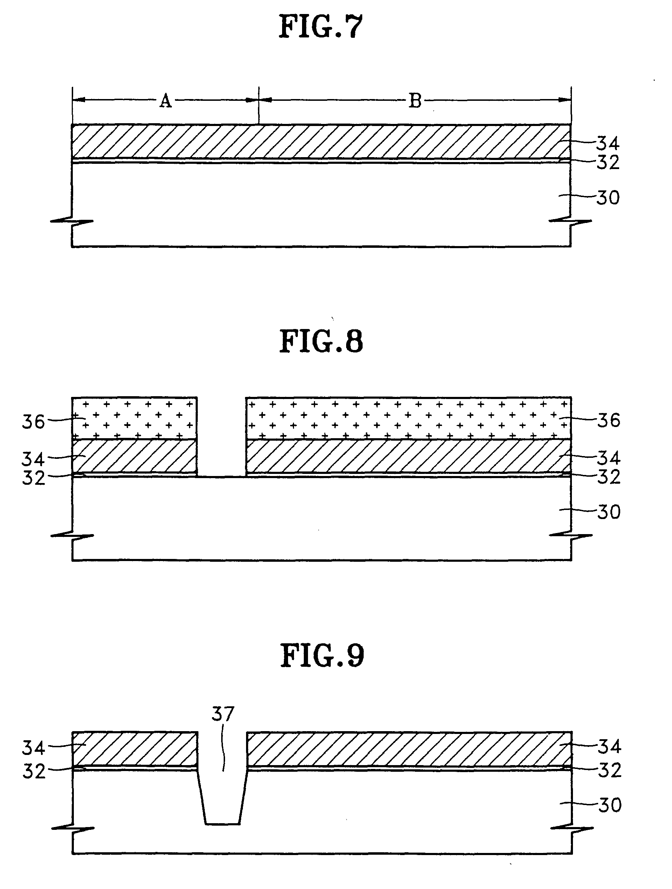

Figs. 7-14 are cross-sectional views for illustrating one embodiment according to process order in order to explain the device isolation method of the semiconductor device by the present invention.

In Fig. 7, "A" portion denotes a cell array region and "B" portion denotes a peripheral region. In Figs. 8 to 14, same reference numeral is given to a region which is corresponding to a region of Fig. 7.

Fig. 7 is a cross sectional view for illustrating a step of forming a pad oxide layer 32 and a first silicon nitride layer 34 on a semiconductor substrate 30, which includes a first step of forming pad oxide layer 32 on semiconductor substrate 30 and a second step of stacking a first silicon nitride layer 34 on pad oxide layer 32.

Specifically, pad oxide layer 32 is formed to a thickness of, for example, about 110Å-240Å by a thermal oxidation method and first silicon nitride layer 34 is formed to a thickness of 1,500Å-2,500Å by, for example, a chemical vapor deposition (CVD) method.

Fig. 8 shows a photolithography step for defining the inactive region of the cell array portion, which includes a first step of forming a first photoresist pattern 36 on first silicon nitride layer 34 and a second step of etching the first silicon nitride layer and the pad oxide layer by using first photoresist pattern 36 as an etching mask.

Specifically, first photoresist pattern 36 is formed to have a shape for exposing the semiconductor substrate of the cell array portion, first silicon nitride layer 34 on the cell array portion is removed by an anisotropic dry etching and pad oxide layer 32 is etched by the reactive ion etching or the wet etching.

Fig. 9 shows a step of forming a trench 37 in the semiconductor substrate of the inactive region of the cell array portion.

Specifically, the first photoresist pattern on the first silicon nitride layer is removed and the semiconductor substrate is etched to have a depth of about 2,000Å-4,000Å by using first silicon nitride layer as the etching mask to thereby form trench 37. In an alternative method step, first photoresist pattern (represented as a reference numeral 36 of Fig. 8) may be used as the etching mask.

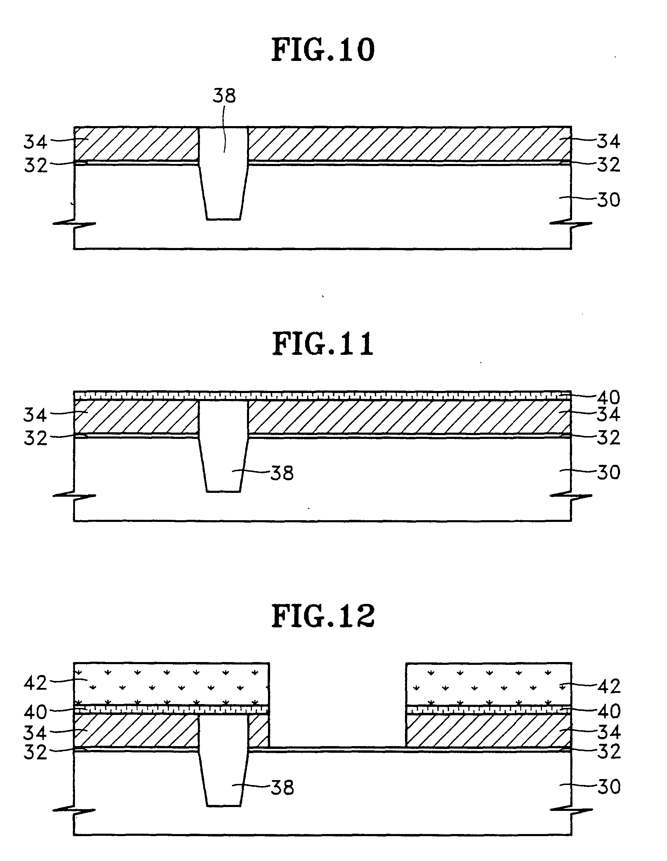

Fig. 10 shows a step of forming a first device isolation layer 38 by filling the trench, which includes a first step of filling the trench with insulating material and a second step of performing CMP over the whole surface of the resultant having trench filled with insulating material.

Specifically, an oxide layer is deposited on the substrate on which the trench is formed by, for example, a CVD method, and then a CMP process is carried out over the whole surface of the resultant having oxide layer thereon until the surface of the first silicon nitride layer 34 is exposed in order to form the oxide layer only inside the trench.

In an alternative method step, reactive ion etching (RIE) is performed instead of the CMP process, or RIE is performed after the CMP process, so that even the first silicon nitride layer may be etched.

Since the trench has a depth of about 2,000Å-4,000Å, the thickness of the CVD oxide layer deposited for filling the trench is at most about 4,000Å, which is very profitable in terms of process time and process margin in comparison with the thickness of about 5,000Å-10,000Å of oxide layer used for filling the trench in a conventional device isolation method using only the trench. Also, since only a narrow trench is formed on the semiconductor substrate and then the oxide layer is deposited, a surface of the substrate planarizes wholly such as not to generate a conventional dishing phenomenon even when a subsequent CMP process is carried out.

The trench isolation is thus realized in the cell array portion by processes from Fig. 7 to Fig. 10.

Fig. 11 shows a step of forming a second silicon nitride layer 40.

Specifically, silicon nitride layer 40 is deposited on the substrate in which first device isolation layer 38 is formed, to a thickness of, for example, 300Å-700Å, which is sufficient to protect the trench portion from an oxidation atmosphere at high temperature, thereby to form second silicon nitride layer 40.

When a peripheral portion is device-isolated by the thermal oxide layer through local oxidation in a subsequent process, second silicon nitride layer 40 has a purpose of prevention of change in electrical characteristic or size which could be caused by oxidation of the trench in a high temperature oxidation atmosphere.

Fig. 12 shows a step of defining the inactive region for isolating the peripheral portion of the semiconductor substrate by a photolithography process. This includes a first step of coating photoresist on second silicon nitride layer 40; the coated photoresist is then patterned to form a second photoresist pattern 42 for exposing the silicon nitride layer on the inactive region of the peripheral portion. It also includes a second step of etching second silicon nitride layer 40 by using the second photoresist pattern as an etching mask and a third step of etching first silicon nitride layer 34 to expose the pad oxide layer on the inactive region of the peripheral portion.

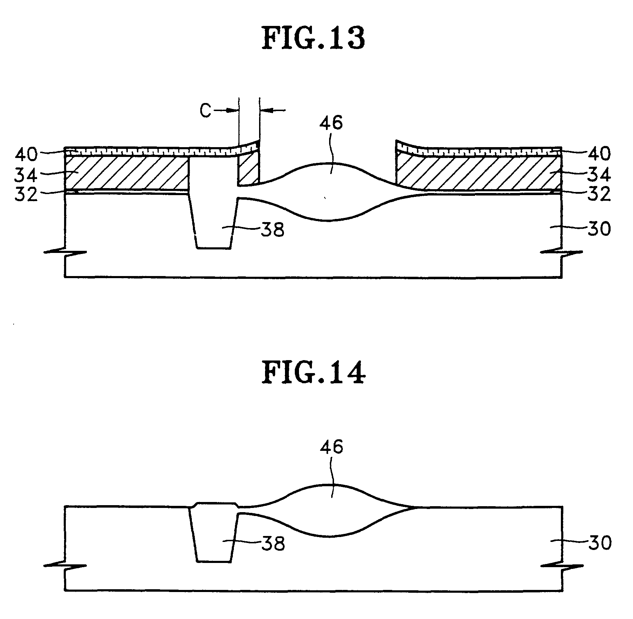

At this time, a misalign margin of the photolithography process is a length "C" as shown in Fig. 13. In other words, in order not to expose the active region at a boundary of the thermal oxide layer and the trench filling oxide layer, a bird's beak generated during a subsequent local oxidation should form the boundary of the trench filling oxide layer and the thermal oxide layer and this boundary should be located within "C" portion. Accordingly, the length of the bird's beak becomes the misalign margin of the photolithography process.

Generally, the length of the bird's beak generated by the local oxidation ranges from 5,000Å to 10,000Å. Accordingly, even though taking into account the situation that the misalign of the photolithography process of a high integration semiconductor device is comparatively loosened 2,000Å, "C" portion of the present invention can be a sufficient margin in the photolithography process.

Fig. 13 shows a step of forming a second device isolation layer 46 in the inactive region of the peripheral portion.

Specifically, second device isolation layer 46 is formed in the inactive region of the peripheral portion, namely, a region where the pad oxide layer is exposed by the photolithography process of Fig. 12, by thermal oxidation at high temperature.

Accordingly, device isolation is realized in the peripheral portion with the thermal oxide layer by the local oxidation, and the active region is not exposed at the boundary of the trench due to the bird's beak generated during forming the thermal oxide layer.

The second silicon nitride layer plays a role in protecting the trench portion from the oxidation atmosphere during the oxidation process.

Fig. 14 shows a step of completing the device isolation by the LOCOS and the trench isolation method of the present invention.

Specifically, the second silicon nitride layer and the first silicon nitride layer are removed by using a wet etching method and then the pad oxide layer is etched by a wet etching method and removed to complete the device isolation process.

At this time, the boundary portion ("C" portion of Fig. 13) of first device isolation layer 38 filled in the trench and second device isolation layer 46 formed by the local oxidation is formed from the thermal oxidation layer, whose etching ratio is lower than that of the CVD oxide layer filled in the trench, at the time of the wet etching process for removing the pad oxide layer, and thus device isolation can be realized without the exposure of the active region.

In the device isolation method by the embodiments of the present invention as described in detail above for a semiconductor device with a cell array portion and a peripheral portion, the device isolation layer by the trench method is formed in a narrow portion and CMP is carried out, so that no dishing phenomenon is generated. Moreover, after the trench isolation process, the device isolation layer is formed in a wide portion by local oxidation so that device isolation can be realized without the exposure of the active region at the boundary of the two device isolation layers, thereby improving the electrical characteristic of the device.

The present invention is not limited to the above embodiment and many variations can be made by those ordinary skilled in the art.

## Claims

1. An isolation method for a semiconductor device, comprising the steps of:
forming a first device isolation layer (38) in a semiconductor substrate, by a trench isolation method including forming a trench to a depth of 2000Å to 4000Å and forming the first device isolation layer in the trench;
then forming a second device isolation layer (46) in the semiconductor substrate by a local oxidation method;
wherein the boundary of said first device isolation layer (38) and said second device isolation layer (46) is formed at a bird's beak region generated during said local oxidation for forming said second device isolation layer, and wherein
the first device isolation layer (38) is formed in a first inactive region in a cell array region (A) of said semiconductor device and said second device isolation layer (46) is formed in a second inactive region in a peripheral region (B) of said cell array region, the second inactive region being wider than the first inactive region,
**characterized in that** the two forming steps form a one-sided structure with a single trench and a single local oxidation region.

2. An isolation method as claimed in claim 1 wherein said first device isolation layer is formed of a chemical vapor deposition oxide layer.

3. An isolation method according to any preceding claim, comprising the steps, in the following order, of:
forming a first pattern (36) on a semiconductor substrate to expose said first inactive region of said substrate;
etching the exposed semiconductor substrate by said first pattern to form a trench (37);
forming the first device isolation layer (38) by filling insulating material in the trench (37);
forming a second pattern (42) on the semiconductor substrate to expose said second inactive region of the substrate; and
forming the second device isolation layer (46) in the second inactive region by local oxidation.

4. An isolation method as claimed in claim 3 wherein, after the step of forming said first device isolation layer (38), said first device isolation layer (38) is etched back by using a chemical-mechanical polishing (CMP) method.

5. An isolation method as claimed in claim 3 wherein, after the step of forming said first device isolation layer (38), said first device isolation layer (38) is etched back by using a reactive ion etching method.

6. An isolation method as claimed in claim 1, comprising the steps, in the following order, of:
forming a pad oxide layer (32) and a first silicon nitride layer (34) on said semiconductor substrate;
forming a first pattern on the semiconductor substrate to expose said first inactive region of said substrate by etching the pad oxide layer (32) and the first silicon nitride layer (34);
etching the semiconductor substrate region exposed by said first pattern to form a trench;
forming a first device isolation layer by filling insulating material in the trench and performing a CMP step over the whole surface of the resultant structure having the trench filled with insulating material;
forming second silicon nitride layer (40) on said first pattern and the first device isolation layer;
forming a second pattern on the semiconductor substrate to expose said second inactive region of the substrate by etching the second silicon nitride layer (40) and the first silicon nitride layer (34); and
forming a second device isolation layer in the second inactive region by local oxidation.

## Patentansprüche

1. Isolierverfahren für eine Halbleiteranordnung umfassend die Schritte:
Ausbilden einer ersten Isolierschicht (38) der Anordnung in einem Halbleitersubstrat nach einem Trench-Isolationsverfahren mit Ausbilden eines Trench in einer Tiefe von 2000 Å bis 4000 Å und Ausbilden einer ersten Isolierschicht im Trench;
dann Ausbilden einer zweiten Isolierschicht (46) der Anordnung im Halbleitersubstrat durch ein lokales Oxidationsverfahren;
worin die Grenze der ersten Isolierschicht (38) der Anordnung und der zweiten Isolierschicht (46) der Anordnung in einem Schnabelbereich ausgebildet ist, der bei der lokalen Oxidation zum Ausbilden der zweiten Isolierschicht der Anordnung gebildet wird, und worin die erste Isolierschicht (38) der Anordnung in einem ersten inaktiven Bereich in einem Zellanordnungsbereich (A) der Halbleiteranordnung ausgebildet wird und die zweite isolierschicht (46) der Anordnung in einem zweiten inaktiven Bereich in einem peripheren Bereich (B) des Zellanordnungsbereichs ausgebildet wird, wobei der zweite inaktive Bereich breiter ist als der erste inaktive Bereich, **dadurch gekennzeichnet, dass** die beiden Ausbildungsschritte eine einseitige Struktur mit einem einzigen Trench und einem einzigen lokalen Oxidationsbereich ausbilden.

2. Isolierverfahren nach Anspruch 1, worin die erste Isolierschicht der Anordnung aus einer chemischen Aufdampfoxidschicht gebildet wird.

3. Isolierverfahren nach einem der vorhergehenden Ansprüche umfassend die Schritte in der folgenden Abfolge:
Ausbilden eines ersten Musters (36) auf einem Halbleitersubstrat, um den ersten inaktiven Bereich des Substrats freizulegen;
Ätzen des freigelegten Halbleitersubstrats in dem ersten Muster, um einen Trench (37) auszubilden;
Ausbilden der ersten Isolierschicht (38) der Anordnung durch Einfüllen von Isoliermaterial in den Trench (37);
Ausbilden eines zweiten Musters (42) auf dem Halbleitersubstrat, um den zweiten inaktiven Bereich des Substrats freizulegen; und
Ausbilden der zweiten Isolierschicht (46) der Anordnung im zweiten inaktiven Bereich durch lokale Oxidation.

4. Isolierverfahren nach Anspruch 3, worin nach dem Schritt zum Ausbilden der ersten Isolierschicht (38) der Anordnung, die erste Isolierschicht (38) der Anordnung unter Verwendung eines chemisch-mechanischen Polierverfahrens (CMP) zurückgeätzt wird.

5. Isolierverfahren nach Anspruch 3, worin nach dem Schritt zum Ausbilden der ersten Isolierschicht (38) der Anordnung, die erste Isolierschicht (38) der Anordnung unter Verwendung eines reaktiven lonenätzverfahrens zurückgeätzt wird.

6. Isolierverfahren nach Anspruch 1, umfassend die Schritte in der folgenden Abfolge:
Ausbilden einer Fülloxidschicht (32) und einer ersten Siliciumnitridschicht (34) auf dem Halbleitersubstrat;
Ausbilden eines ersten Musters auf dem Halbleitersubstrat, um den ersten inaktiven Bereich des Substrats durch Ätzen der Fülloxidschicht (32) und der ersten Siliciumnitridschicht (34) freizulegen;
Ätzen des in dem ersten Muster freigelegten Halbleitersubstratbereichs, um einen Trench auszubilden;
Ausbilden einer ersten Isolierschicht der Anordnung durch Einfüllen von Isoliermaterial in den Trench und Durchführen eines CMP-Schritts über die gesamte Oberfläche der erhaltenen Struktur, wobei der Trench mit Isoliermaterial gefüllt ist;
Ausbilden einer zweiten Siliciumnitridschicht (40) auf dem ersten Muster und der ersten Isolierschicht der Anordnung;
Ausbilden eines zweiten Musters auf dem Halbleitersubstrat, um den zweiten inaktiven Bereich des Substrats durch Ätzen der zweiten Siliciumnitridschicht (40) und der ersten Siliciumnitridschicht (34) freizulegen; und
Ausbilden einer zweiten Isolierschicht der Anordnung im zweiten inaktiven Bereich durch lokale Oxidation.

## Revendications

1. Méthode d'isolation d'un dispositif semi-conducteur, comprenant les étapes consistant à :
former une première couche d'isolation de dispositif (38) dans un substrat semi-conducteur, au moyen d'une méthode d'isolation par tranchée comprenant la formation d'une tranchée à une profondeur de 2000 Å à 4000 Å et la formation de la première couche d'isolation de dispositif dans la tranchée ;
puis former une seconde couche d'isolation de dispositif (46) dans le substrat semi-conducteur au moyen d'une méthode d'oxydation locale ;
dans laquelle la frontière de ladite première couche d'isolation de dispositif (38) et de ladite seconde couche d'isolation de dispositif (46) est formée au niveau d'une région en bec d'oiseau générée pendant ladite oxydation locale pour former ladite seconde couche d'isolation de dispositif, et dans laquelle
la première couche d'isolation de dispositif (38) est formée dans une première région inactive dans une région de matrice de cellules (A) dudit dispositif semi-conducteur et ladite seconde couche d'isolation de dispositif (46) est formée dans une seconde région inactive dans une région périphérique (B) de ladite région de matrice de cellules, la seconde région inactive étant plus grande que la première région inactive, **caractérisée en ce que** les deux étapes de formation forment une structure monoface avec une seule tranchée et une seule région d'oxydation locale.

2. Méthode d'isolation selon la revendication 1, dans laquelle ladite première couche d'isolation de dispositif est formée d'une couche d'oxyde de dépôt chimique en phase vapeur.

3. Méthode d'isolation selon l'une quelconque des revendications précédentes, comprenant les étapes dans l'ordre qui suit consistant à :
former un premier motif (36) sur un substrat semi-conducteur pour exposer ladite première région inactive dudit substrat ;
graver le substrat semi-conducteur exposé avec ledit premier motif pour former une tranchée (37) ;
former la première couche d'isolation de dispositif (38) en remplissant de matériau isolant la tranchée (37) ;
former un second motif (42) sur le substrat semi-conducteur pour exposer ladite seconde région inactive du substrat ; et
former la seconde couche d'isolation de dispositif (46) dans la seconde région inactive par oxydation locale.

4. Méthode d'isolation selon la revendication 3, dans laquelle, après l'étape de formation de ladite première couche d'isolation de dispositif (38), ladite première couche d'isolation de dispositif (38) est gravée en retrait en utilisant une méthode de polissage chimique-mécanique (CMP).

5. Méthode d'isolation selon la revendication 3, dans laquelle, après l'étape de formation de ladite première couche d'isolation de dispositif (38), ladite première couche d'isolation de dispositif (38) est gravée en retrait en utilisant une méthode de gravure par ions réactifs.

6. Méthode d'isolation selon la revendication 1, comprenant les étapes dans l'ordre qui suit consistant à :
former une couche d'oxyde tampon (32) et une première couche de nitrure de silicium (34) sur ledit substrat semi-conducteur ;
former un premier motif sur le substrat semi-conducteur pour exposer ladite première région inactive dudit substrat en gravant la couche d'oxyde tampon (32) et la première couche de nitrure de silicium (34) ;
graver la région exposée du substrat semi-conducteur avec ledit motif pour former une tranchée ;
former une première couche d'isolation de dispositif en remplissant de matériau isolant la tranchée et effectuer une étape de CMP sur toute la surface de la structure résultante ayant la tranchée remplie de matériau isolant ;
former une seconde couche de nitrure de silicium (40) sur ledit premier motif et la première couche d'isolation de dispositif ;
former un second motif sur le substrat semi-conducteur pour exposer ladite seconde région inactive du substrat en gravant la seconde couche de nitrure de silicium (40) et la première couche de nitrure de silicium (34) ; et
former une seconde couche d'isolation de dispositif dans la seconde région inactive par oxydation sélective.
